Europäisches Patentamt

European Patent Office

Office européen des brevets

(19)

(11) EP 0 582 526 B1

# (12) FASCICULE DE BREVET EUROPEEN

(45) Date de publication et mention
de la délivrance du brevet:
**09.12.1998 Bulletin 1998/50**

(51) Int Cl.⁶: **G01R 31/36**

(21) Numéro de dépôt: **93420300.1**

(22) Date de dépôt: **13.07.1993**

(54) **Procédé de détermination du temps d'autonomie d'une batterie**

Verfahren zur Bestimmung der Batterieentladungszeit

Method for determining battery discharge time

(84) Etats contractants désignés:
**BE DE ES GB IT NL**

(30) Priorité: **05.08.1992 FR 9209818**

(43) Date de publication de la demande:
**09.02.1994 Bulletin 1994/06**

(73) Titulaire: **MGE-UPS SYSTEMS**
**38240 Meylan (FR)**

(72) Inventeurs:
• **Fiorina, Jean-Noel**
**F-38050 Grenoble Cédex 09 (FR)**

• **Lailler, Patrick**
**F-38050 Grenoble Cédex 09 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
**US-A- 4 952 862**

• **NTT REVIEW vol. 3, no. 4, Juillet 1991, TOKYO JP pages 89 - 97 S. ISHIZUKA ET AL. 'Equipment for the Calculation of Battery Remaining Discharge Time in Telecommunication Systems'**

**Description**

L'invention concerne un procédé de détermination de la durée d'autonomie d'une batterie, comportant la mesure de la tension aux bornes de la batterie, du courant de charge et de décharge de la batterie, le calcul, à partir des valeurs de tension et de courant mesurées, de la puissance de décharge de la batterie et la détermination de la durée d'autonomie de la batterie en fonction de la puissance de décharge.

Il est connu de déterminer le temps d'autonomie d'une batterie d'accumulateurs, notamment d'une batterie d'accumulateurs d'une alimentation sans coupure, en tenant compte du courant débité par la batterie, de la tension mesurée à ses bornes et de courbes de décharge de la batterie, obtenues expérimentalement ou fournies par le fabricant de batteries (GB-A-2 221 046).

Dans les systèmes connus à microprocesseur les courbes de décharge de la batterie sont enregistrées, par exemple sous forme de tables, dans une mémoire associée au microprocesseur.

Les courbes de décharge sont différentes pour chaque type de batterie et ne sont pas toujours fournies sous la même forme par les fournisseurs. Il est nécessaire de mettre en mémoire dans le dispositif de détermination du temps d'autonomie, les courbes correspondant à la batterie utilisée. Cette mise en mémoire nécessite une capacité de mémoire importante. De plus elle ne permet que difficilement de prendre en compte le vieillissement de la batterie, son état de charge réel et les variations de charge en cours de décharge.

L'invention a pour but d'écarter ces inconvénients.

Selon l'invention, la détermination de la durée d'autonomie comporte la simulation, de manière itérative, de la décharge de la batterie pendant des intervalles de temps simulés successifs, ladite simulation comportant, pour chaque intervalle de temps simulé, le calcul d'une tension simulée aux bornes de la batterie en tenant compte de la puissance de décharge et de paramètres prédéterminés caractéristiques de la batterie, la comparaison de la tension simulée à une tension minimum de décharge de la batterie, et la sommation des intervalles de temps simulés successifs, la durée d'autonomie de la batterie étant égale à la somme des intervalles de temps obtenue lorsque la tension simulée atteint la tension minimum de décharge.

Selon un mode particulier de réalisation, le calcul de la tension simulée comporte le calcul d'un courant de décharge simulé, et le calcul d'un état de charge simulé de la batterie. Le calcul du courant de décharge simulé est réalisé conformément à l'équation :

$$i = (Eo - \sqrt{Eo^2 - 4RP})/2R$$

dans laquelle Eo est une tension équivalente caractéristique de la batterie, R la résistance interne de la batterie et P la puissance de décharge de la batterie.

Le calcul de l'état de charge simulé est, de préférence, réalisé à chaque intervalle de temps simulé par soustraction à l'état de charge simulé précédent du rapport entre le produit du courant simulé et de l'intervalle de temps et d'un paramètre caractéristique de la batterie, représentatif de sa capacité. La résistance interne de la batterie est calculée pendant chaque intervalle de temps simulé, à partir d'un paramètre caractéristique de la batterie, représentatif de sa résistance interne lorsqu'elle est complètement chargée, et de l'état de charge simulé de la batterie.

Le procédé peut, de plus, comporter le calcul de l'état de charge réel de la batterie, ledit état de charge réel étant utilisé comme état de charge simulé initial lors de la simulation de la décharge de la batterie.

Il peut aussi comporter la réactualisation des paramètres caractéristiques de la batterie, représentatifs de sa résistance interne à l'état complètement chargé et de sa capacité, pour tenir compte du vieillissement de la batterie.

Selon un mode de réalisation préférentiel, la réactualisation de la résistance interne de la batterie à l'état complètement chargé comporte une augmentation progressive prédéterminée de ladite résistance interne. La réactualisation de la capacité de la batterie comporte le calcul d'une nouvelle valeur de la capacité égale au rapport entre une valeur réactualisée de la résistance interne de la batterie à l'état complètement chargé et un coefficient obtenu en faisant le produit des valeurs initiales de la capacité et de la résistance interne à l'état complètement chargé.

Le procédé peut également comporter la détermination de la durée de vie restante de la batterie à partir de la détermination de sa durée d'autonomie .

D'autres avantages et caractéristiques ressortiront plus clairement de la description qui va suivre, d'un mode de mise en oeuvre de l'invention illustré sur les dessins annexés, sur lesquels:

La figure 1 illustre de façon schématique, un dispositif mettant en oeuvre le procédé selon l'invention pour la détermination du temps d'autonomie d'une batterie d'une alimentation sans coupure.

La figure 2 représente un circuit équivalent de la batterie.

La figure 3 représente un organigramme général représentatif du fonctionnement du dispositif selon la figure 1.

La figure 4 représente plus en détail un mode de réalisation de la phase de calcul du temps d'autonomie de l'organigramme selon la figure 3.

La figure 5 représente plus en détail un mode de réalisation de la phase de calcul de la puissance et de l'état de charge de la batterie de l'organigramme de la figure 3.

La figure 6 représente plus en détail une phase de mise à jour de l'état de charge de la batterie lors de la charge de celle-ci.

La figure 7 illustre plus en détail la phase d'initialisation de l'organigramme selon la figure 3.

La figure 8 représente une phase de réactualisation de la résistance interne initiale de la batterie.

La figure 9 illustre un mode particulier de réalisation d'une phase additionnelle de réactualisation de la capacité de la batterie.

La figure 10 illustre la relation entre la durée de vie restante de la batterie et son temps d'autonomie.

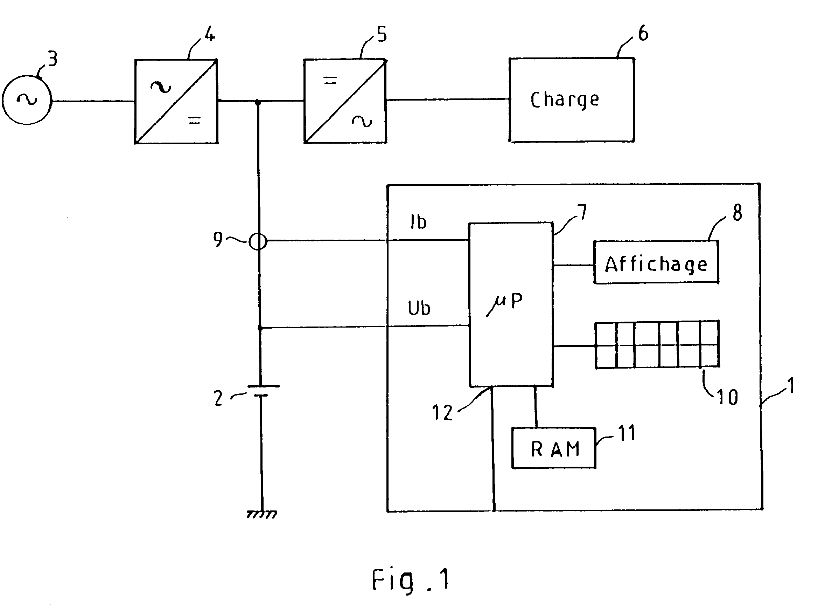

La figure 1 illustre l'application d'un dispositif 1 de détermination du temps d'autonomie d'une batterie à une batterie 2 d'une alimentation sans coupure. L'alimentation sans coupure, de type classique, représentée schématiquement sur la figure, est alimentée par une source 3 de tension alternative et comporte un convertisseur alternatif-continu 4 connecté en série avec un convertisseur continu-alternatif, ou onduleur, 5 et une charge 6, la batterie 2 étant connectée à la sortie du convertisseur 4.

Le dispositif 1 comporte un circuit électronique de traitement 7, à microprocesseur, connecté à un dispositif d'affichage 8. Le circuit électronique de traitement 7 reçoit en entrée des signaux représentatifs du courant Ib de charge ou de décharge de la batterie, fournis par un capteur de courant 9, et des signaux représentatifs de la tension Ub aux bornes de la batterie.

Le circuit 7 comporte également des moyens d'entrée de paramètres. Les moyens d'entrée sont, sur la figure, représentés sous la forme d'un clavier 10, mais peuvent bien entendu prendre toute autre forme équivalente. Le microprocesseur est, de façon classique, connecté à des moyens de mémorisation 11, RAM et registres, permettant la mise en mémoire des paramètres, des valeurs mesurées (Ib, Ub) et des différentes valeurs calculées.

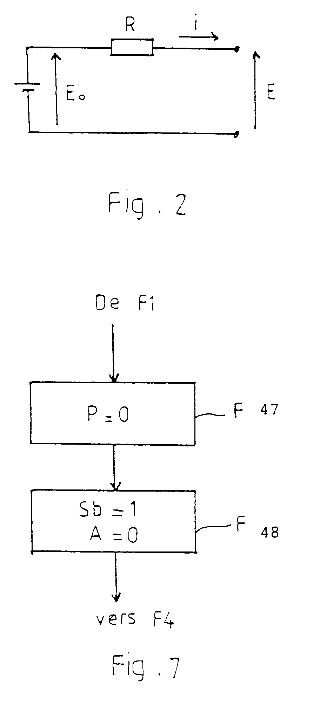

La batterie est considérée comme équivalente au circuit représenté à la figure 2 et comportant en série une source de tension continue constante Eo et une résistance interne R. Si i est le courant fourni par la batterie et E la tension aux bornes de la batterie, l'équation :

$$E = Eo - Ri \qquad (1)$$

est vérifiée.

La résistance interne de la batterie peut être exprimée sous la forme:

$$R = Ro / S^k \qquad (2)$$

où Ro est la résistance interne de la batterie lorsqu'elle est complètement chargée, c'est à dire lorsque son état de charge S = 1, et où k est un coefficient propre à la batterie.

L'état de charge de la batterie peut s'exprimer sous la forme :

$$S = 1 - \int i\,dt/C \qquad (3)$$

où C est la capacité de la batterie, exprimée en A·h. P = Ei étant la puissance fournie par la batterie, le courant i peut alors être exprimé sous la forme :

$$i = (Eo - \sqrt{Eo^2 - 4RP})/2R \qquad (4)$$

Ce modèle mathématique est utilisé pour déterminer le temps d'autonomie de la batterie.

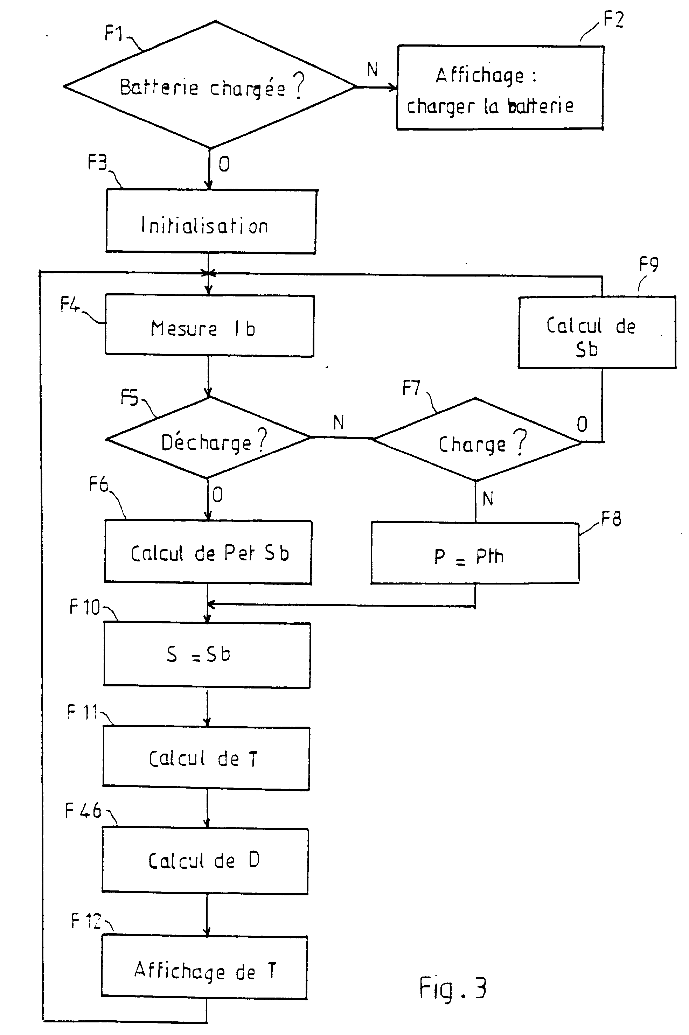

Le microprocesseur du circuit de traitement 7 réalise successivement les diverses phases de l'organigramme général représenté à la figure 3.

Lors de la première mise en route du dispositif pour déterminer l'autonomie d'une batterie 2, le microprocesseur vérifie (F1) que la batterie est chargée. Cette information peut être fournie au dispositif par tout moyen approprié, par exemple au moyen d'un signal logique A1 appliqué sur une entrée 12 (figure 1) du circuit de traitement et fourni par un dispositif de supervision externe (non représenté) ou par l'actionnement d'un interrupteur disposé sur le dispositif 1, par exemple après un temps minimal de charge (12h par exemple). Si la batterie n'est pas chargée (A1 = O), le microprocesseur assure l'affichage, sur le dispositif d'affichage 8, d'une information correspondante, par exemple: "Charger la batterie" (F2).

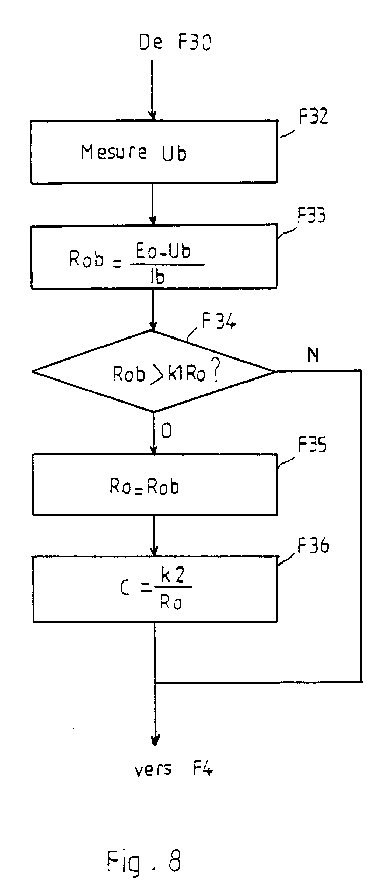

Lorsque la batterie est chargée (A1 = 1), le microprocesseur passe à une phase d'initialisation (F3) qui sera décrite plus en détail ultérieurement en référence à la figure 7.

Après la phase d'initialisation, une détermination du temps d'autonomie T de la batterie est réalisée à intervalles réguliers (ΔT1), par exemple toutes les secondes. Cette détermination commence par une lecture (F4) par le microprocesseur du courant Ib, fourni par le capteur de courant 9. Puis, le microprocesseur vérifie (F5) s'il s'agit d'un courant de décharge (F5). Cette information peut être fournie au dispositif par tout moyen approprié, par exemple au moyen d'un second signal logique A2 appliqué sur l'entrée 12 du circuit de traitement ou par détermination du signe du courant Ib.

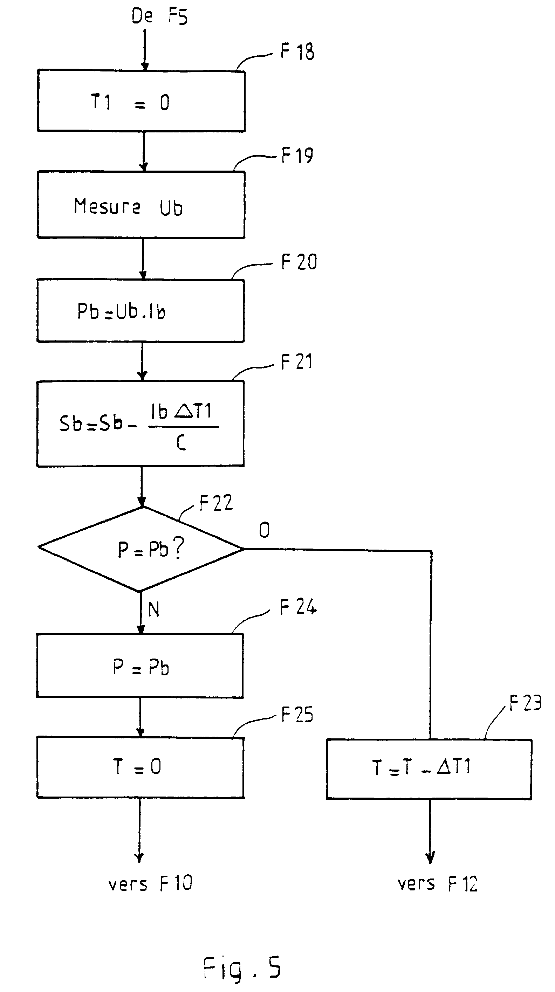

Si la batterie est dans un cycle de décharge (A2 = 1), le microprocesseur calcule ensuite (F6) la puissance P fournie par la batterie et son état de charge réel Sb. Cette phase de calcul sera décrite plus en détail ultérieurement en référence à la figure 5.

Si la batterie n'est pas en décharge (A2 = O), le microprocesseur vérifie (F7) si elle est dans une période de charge ou si elle n'est pas sollicitée. Cette information peut être fournie par un troisième signal logique A3 appliqué à l'entrée 12, à 1 en cas de charge et à 0 dans le cas contraire ou par la comparaison du courant mesuré à O, 1b étant nul si la batterie n'est pas sollicitée.

Si la batterie n'est pas sollicitée (sortie N de F7), le microprocesseur prend (F8) comme valeur de la puissance P une puissance théorique Pth, arbitrairement choisie, préalablement mise en mémoire dans les moyens de mémorisation 11. Cette puissance théorique peut correspondre par exemple à la pleine puissance de l'alimentation contenant la batterie, à la moitié de celle-ci ou à la puissance réelle délivrée par l'alimentation.

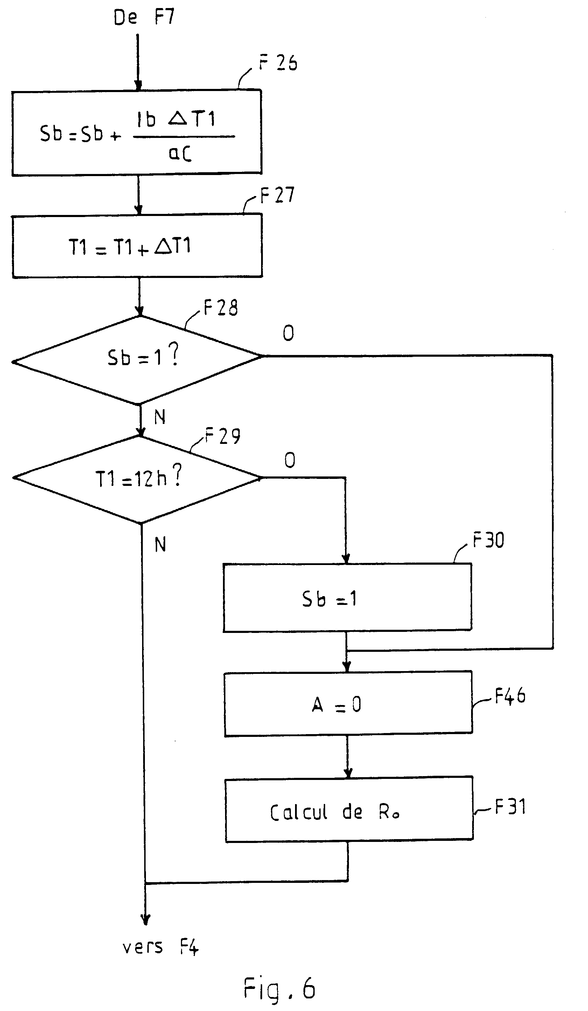

Sur la figure 3, pendant la charge de la batterie (sortie O de F7), la durée d'autonomie n'est pas calculée, mais le microprocesseur peut (F9) mettre à jour l'état de charge réel Sb de la batterie, de la manière décrite plus en détail ultérieurement en référence à la figure 6, avant de se reboucler à l'entrée de F4 pour un nouveau cycle de détermination du temps d'autonomie. Selon une variante, non représentée, le microprocesseur peut calculer la durée d'autonomie pendant la charge de la même manière que lorsque la batterie n'est pas sollicitée, en prenant en compte l'état de charge réel de la batterie calculé en F9.

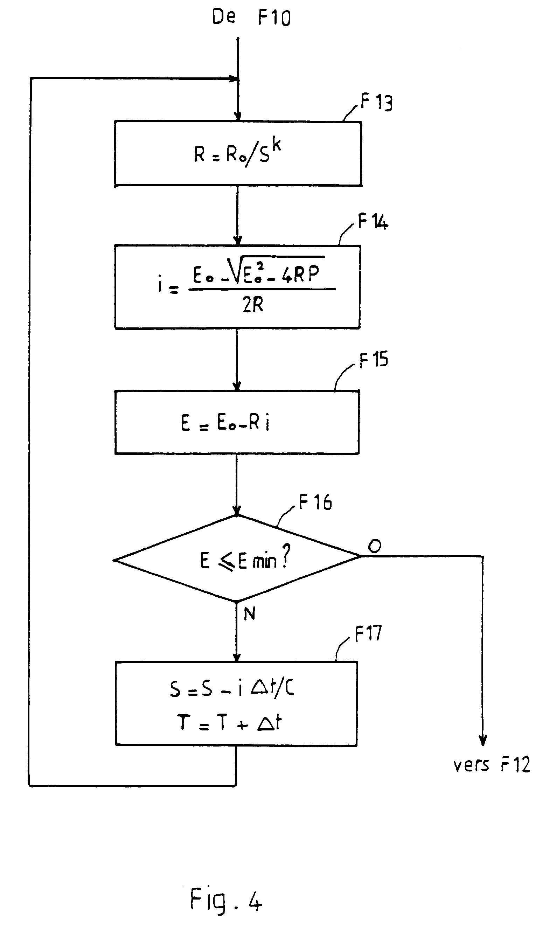

Après les phases F6 ou F8, le microprocesseur prend (F10) comme état de charge S l'état de charge réel Sb de la batterie, puis procède (F11) au calcul du temps d'autonomie T. Cette phase de calcul de T sera décrite plus en détail ultérieurement en référence à la figure 4. Le microprocesseur contrôle ensuite (F12) l'affichage du temps d'autonomie T, sur le dispositif d'affichage 8, avant de se reboucler à l'entrée de F4 pour un nouveau cycle de détermination du temps d'autonomie.

La phase F11 de calcul de T est représentée à la figure 4. Cette phase commence par une phase 13 de calcul de la résistance interne R de la batterie conformément à l'équation (2). Les valeurs Ro et k, caractéristiques de la batterie et obtenues à partir des données fournies par le constructeur ont été mises en mémoire dans la mémoire 11, tandis que l'état de charge S a été déterminé pendant la phase F10. La phase F13 est suivie par une phase F14 de calcul du courant simulé i fourni par la batterie, conformément à l'équation (4), à partir des valeurs de R et de P préalablement calculées respectivement pendant les phases F13 et F6 ou F8 et de la valeur Eo, caractéristique de la batterie et mise en mémoire dans la mémoire 11.

La phase F14 est suivie d'une phase F15 de calcul de la tension E simulée aux bornes de la batterie, conformément à l'équation (1). Puis (F16) la tension E simulée est comparée à une valeur Emin prédéterminée, correspondant à la valeur minimum, prédéterminée, de la tension de décharge de la batterie.

Si E est supérieur Emin (sortie N de F16), la phase suivante, F17, consiste à calculer le nouvel état de charge S après une décharge de durée prédéterminée Δt en calculant une nouvelle valeur S = S - i Δt / C. La valeur C de la capacité de la batterie, obtenue à partir des données fournies par le constructeur, a été auparavant mise en mémoire dans la mémoire 11. Simultanément la valeur T, qui est nulle au début de la phase 11, est remplacée par T + Δt, puis le microprocesseur revient à l'entrée de la phase F13.

Ce processus de calcul, F13 à F17, se répète aussi longtemps que la tension E simulée reste supérieure ou égale à Emin. Il simule ainsi, de manière itérative, à partir du modèle mathématique décrit en référence à la figure 2, la décharge de la batterie à partir de son état de charge réel Sb pendant des intervalles de temps simulés Δt successifs, en tenant compte des valeurs Ro, k, Eo et C caractéristiques de la batterie considérée et de sa puissance réelle P. La somme des intervalles de temps simulés Δt nécessaires pour que E devienne inférieur à Emin correspond au temps d'autonomie T de la batterie. Ce temps est affiché (phase F12) lorsque la tension E simulée est devenue inférieure à Emin (sortie O de F16).

L'utilisation d'un modèle mathématique permettant de simuler la décharge avec un pas Δt très faible par rapport aux temps d'autonomie habituels permet d'obtenir des valeurs relativement précises de T, sans nécessiter l'entrée en mémoire de courbes caractéristiques de la batterie. A titre d'exemple, le pas Δt peut être compris entre 10 et 30s.

Le modèle utilisé est autoadaptatif dans la mesure où le calcul de T tient compte de la puissance réelle P débitée par la batterie et, de préférence, de son état de charge réel Sb. De plus, il est possible de tenir compte de son vieillissement en modifiant les valeurs initiales Ro et C ainsi que cela sera décrit plus en détail ultérieurement.

La phase F6 est représenté plus en détail à la figure 5. Dans une première phase, F18, une grandeur T1, dont la signification sera explicitée en référence à la figure 6, est mise à O. Puis (F19) la valeur de la tension Ub aux bornes de la batterie 2 est lue par le microprocesseur, et la puissance Pb = Ub•b de la batterie est calculée (F20). L'état de charge réel de la batterie, Sb, est mis à jour (F21) pour tenir compte de la décharge d'un courant Ib pendant l'intervalle de temps ΔT1:

$$Sb = Sb - Ib\Delta T1 /C \qquad (5)$$

Si la puissance est restée constante depuis le précédent cycle de détermination du temps d'autonomie il est possible de faire une simple mise à jour de ce temps. Pour cela, la puissance P calculée pendant le cycle précédent est comparée à la puissance Pb pendant une phase F22. Si P=Pb (sortie O de F22), le nouveau temps d'autonomie est donné (F23) par:

$$T = T - \Delta T1 \qquad (6)$$

puis affiché (F12).

Par contre, si la puissance a évolué (sortie N de F22),qu'elle ait augmenté ou diminué, il est nécessaire de refaire le calcul du temps d'autonomie en tenant compte de la nouvelle valeur de la puissance et de l'état de charge réel Sb. Dans une phase F24, le microprocesseur prends alors comme puissance P la puissance Pb, puis (F25) initialise à O le temps d'autonomie T pour permettre ensuite (F10 et F11) un nouveau calcul de T, par simulation d'une décharge.

La mise à jour de l'état de charge réel Sb en cas de charge de la batterie (F9) est représenté plus en détail sur la figure 6. Dans une phase F26, la nouvelle valeur de Sb est calculée selon l'équation :

$$Sb = Sb + (Ib\Delta T1/aC) \qquad (7)$$

dans laquelle a est un coefficient tenant compte du rendement de la batterie. A titre d'exemple, le coefficient a peut varier entre 1,12 pour une batterie neuve et 1,14 pour une batterie usagée et peut être choisi égal à 1,13.

La durée T1 de la charge, qui est remise à zéro pendant la phase F18 de F5 dès qu'il y a décharge, est mise à jour en F27 :

$$T1 = T1 + \Delta T1 \qquad (8)$$

Lorsque l'état réel de la charge, Sb, atteint 1 (sortie O de F28), le microprocesseur reprend, éventuellement après une phase F31 de calcul de Ro, le cycle de détermination en F4. Pour éviter des erreurs dues aux mesures, le paramètre Sb est remis à 1 au bout de 12h de charge. Si Sb n'est pas égal à 1 (sortie N de F28) et si T1 = 12h (sortie O de F29), pendant une phase F30 le microprocesseur prend 1 comme valeur de Sb avant de retourner, éventuellement après la phase F31, à l'entrée de F4. Sinon (sortie N de F29), le microprocesseur conserve la nouvelle valeur de Sb calculée en F26 et retourne à l'entrée de F4.

Pendant la phase F3 d'initialisation, représentée plus en détail à la figure 7, la puissance P est mise à zéro (F47) et la valeur de Sb à 1 (en F48).

Lorsqu'une batterie vieillit sa résistance interne augmente et sa capacité diminue. Les valeurs de Ro et de C, initialement mises en mémoire dans la mémoire 11, peuvent être réactualisées périodiquement pour tenir compte de ce phénomène.

Une phase F31 de réactualisation Ro peut être réalisée lorsque la batterie est complètement chargée (S = 1), par exemple après la phase F30 de la figure 6.

Lorsque la batterie est complètement chargée

$$Ub = Eo - RoIb \qquad (9)$$

On peut donc déduire une nouvelle valeur Rob des valeurs de Ub et Ib mesurées, selon l'équation :

$$Rob = (Eo - Ub)/Ib \qquad (10)$$

La phase F31 de réactualisation de Ro peut alors comporter, comme illustré à la figure 8, une phase F32 de mesure de Ub, suivie d'une phase F33 de calcul de la valeur mesurée Rob de la résistance interne initiale Ro selon l'équation (10).

Si la nouvelle valeur Rob s'écarte de la valeur Ro précédemment mise en mémoire de plus d'un seuil prédéterminé, la valeur Ro est remplacée par la nouvelle valeur. Rob est donc comparé à k1Ro dans une phase F34, k1 étant un coefficient de valeur prédéterminée. A titre d'exemple k1 = 1,05, la nouvelle valeur étant donc prise en compte dès que son écart avec la précédente est supérieure à 5%. Si Rob est supérieur à k1Ro (sortie O de F34), alors Rob remplace Ro dans la mémoire 11. Sinon (sortie N de F34), Ro reste inchangé.

Dans un mode de réalisation préférentiel, représenté à la figure 8, toute modification (F35) de Ro est suivie (F36) d'une modification correspondante de C suivant l'équation :

$$C = k2/Ro \qquad (11),$$

le produit de Ro et de C étant considéré comme constant, k2 étant un coefficient prédéterminé correspondant au produit RoC initialement mis en mémoire.

La réactualisation de C peut également être effectuée lorsque la tension Ub aux bornes de la batterie a atteint sa tension minimale Emin. Une telle réactualisation peut être effectuée systématiquement, en cas de décharge, pendant la phase F6 de calcul de P et Sb, dans une phase additionnelle insérée entre les phases F19 et F20 ou F20 et F21 (figure 5).

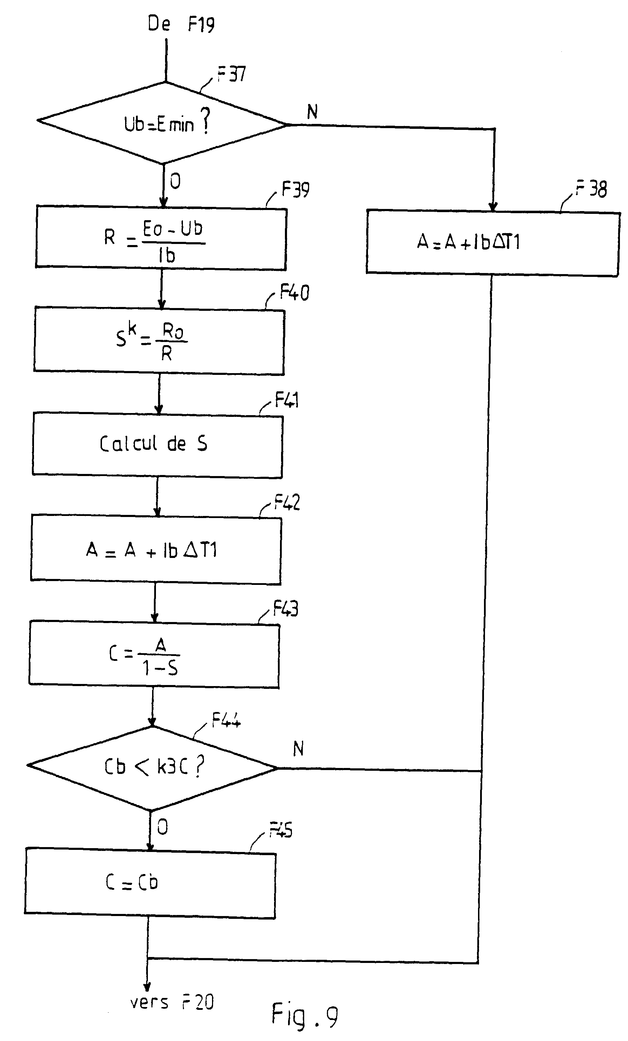

Un mode de réalisation particulier de cette phase additionnelle de réactualisation est représenté plus en détail à la figure 9. La tension Ub est d'abord (F37) comparée à Emin. Si Ub n'est pas égale à Emin (sortie N de F37), une grandeur A, correspondant aux Ah consommés par la batterie depuis le début de la décharge est calculée (F38) selon l'équation :

$$A = A + Ib\Delta T1 \qquad (12)$$

La grandeur A est mise à zéro chaque fois que la batterie est complètement chargée, c'est à dire pendant la phase F32 (figure 7) de la phase d'initialisation et pendant une phase F46 suivant la sortie O de la phase 28 ou la phase F30 (figure 6) en cas de recharge de la batterie.

En fin de décharge (sortie O de F37), la résistance interne R de la batterie est calculée (F39) :

$$R = (Eo - Ub)/Ib \qquad (13)$$

puis (F40) $S^k$ est calculé :

$$S^k = Ro/R \qquad (14)$$

Puis (F41) S est déduit de $S^k$, et la grandeur A mise à jour (F42). La nouvelle valeur Cb de la capacité est alors (F43) calculée conformément à l'équation :

$$Cb = A/(1- S) \qquad (15)$$

Si la nouvelle valeur Cb s'écarte de la valeur C précédemment mise en mémoire de plus d'un seuil prédéterminé, la valeur C est remplacée par la nouvelle valeur. Cb est donc comparé à k3C dans une phase F44, k3 étant un coefficient de valeur prédéterminée, par exemple k3 = 0,95. Si Cb est inférieur à k3C (sortie 0 de F44), alors Cb remplace C dans la mémoire 11. Sinon (sortie N de F44), C reste inchangé.

Dans le cas où la batterie n'est pas sollicitée pendant des périodes très longues, il peut être avantageux de réactualiser systématiquement les valeurs de Ro et de C. En effet, la batterie vieillit même en l'absence d'utilisation, sa durée de vie D, par exemple 5 ans, correspondant au temps nécessaire pour que son autonomie soit réduite à la moitié de sa valeur initiale. Selon un mode de réalisation préférentiel, la valeur de Ro est augmentée progressivement tandis que la capacité C est diminuée progressivement, le produit RoC étant maintenu constant. On simule ainsi une diminution linéaire de l'autonomie de la batterie dans le temps . Cette réactualisation peut être commandée systématiquement à intervalles de temps réguliers, par exemple une fois par mois, par exemple par application d'un signal approprié à l'entrée 12 du microprocesseur par le circuit de contrôle de l'installation ou par tout circuit de supervision approprié.

Pour améliorer encore la précision il est possible de corriger également la valeur de C en fonction de la température à partir d'une relation entre C et la température fournie par le constructeur de la batterie. Initialement la valeur C mémorisée est la valeur correspondant à une température prédéterminée, par exemple 20 ou 25°C.

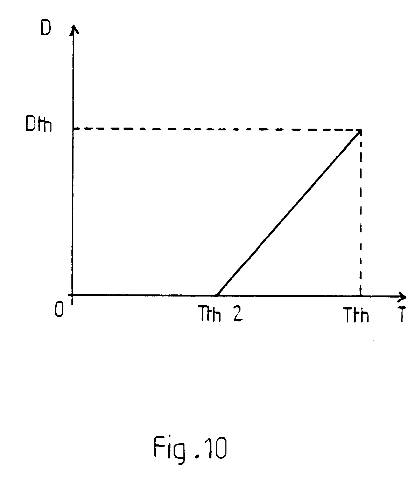

La détermination du temps d'autonomie peut être utilisée pour détecter l'imminence d'un défaut de la batterie. En effet, le temps d'autonomie d'une batterie est normalement divisé par deux à la fin de sa durée de vie. La surveillance de l'évolution du temps d'autonomie T peut fournir une indication sur sa durée de vie restante. Tth étant le temps d'autonomie théorique de la batterie, la batterie est considérée comme morte lorsque T = Tth/2. La figure 10 illustre la relation entre la durée de vie restante D et le temps d'autonomie T de la batterie, la durée de vie théorique Dth, par exemple 5 ans, correspondant à un temps d'autonomie Tth, par exemple 10min. Lorsque T = Tth/2, la durée de vie restante est nulle. Par extrapolation, il est possible, à chaque détermination de T de déterminer la durée de vie restante de la batterie. Si la courbe D (T) est linéaire comme sur la figure 10, elle peut s'écrire sous la forme :

$$D = 2 \, Dth \times (T/Tth) - Dth \qquad (16)$$

Les valeurs Dth et Tth étant préalablement mises en mémoire dans la mémoire 11, le microprocesseur, peut à chaque nouveau calcul de T, en déduire la valeur de la durée de vie réelle D de la batterie, conformément à l'équation (14).

Un tel calcul de D peut par exemple être réalisé automatiquement après la phase F11 (figure 3) de calcul de T, pendant une phase additionnelle F46.

Cette phase additionnelle F46 peut aussi comporter une phase de comparaison à un seuil minimum prédéterminé, une alarme de défaut imminent étant alors actionnée par le microprocesseur si D est inférieur à ce seuil.

## Revendications

1. Procédé de détermination de la durée d'autonomie (T) d'une batterie (2), comportant la mesure (F19, F4) de la tension (Ub) aux bornes de la batterie, du courant (Ib) de charge et de décharge de la batterie, le calcul (F6, F20), à partir des valeurs de tension et de courant mesurées, de la puissance (Pb) de décharge de la batterie et la détermination de la durée d'autonomie (T) de la batterie en fonction de la puissance de décharge, procédé caractérisé en ce que la détermination de la durée d'autonomie (T) comporte la simulation (F11), de manière itérative, de la décharge de la batterie pendant des intervalles de temps (Δt) simulés successifs, ladite simulation comportant, pour chaque intervalle de temps simulé, le calcul (F13, F14, F15, F17) d'une tension simulée (E) aux bornes de la batterie en tenant compte de la puissance de décharge (Pb) et de paramètres prédéterminés (Ro, C, k) caractéristiques de la batterie, la comparaison (F16) de la tension simulée (E) à une tension (Emin) minimum de décharge de la batterie, et la sommation (F17) des intervalles de temps simulés successifs, la durée (T) d'autonomie de la batterie étant égale à la somme des intervalles de temps obtenue lorsque la tension simulée (E) atteint la tension (Emin) minimum de décharge.

2. Procédé selon la revendication 1, caractérisé en ce que le calcul de la tension simulée (E) comporte le calcul (F14) d'un courant de décharge (i) simulé, et le calcul (F17) d'un état de charge (S) simulé de la batterie.

3. Procédé selon la revendication 2, caractérisé en ce que le calcul (F14) du courant de décharge (i) simulé est réalisé conformément à l'équation

$$i = (Eo - \sqrt{Eo^2 - 4RP})/2R,$$

dans laquelle Eo est une tension équivalente caractéristique de la batterie, R la résistance interne de la batterie et P la puissance de décharge de la batterie.

4. Procédé selon l'une des revendications 2 et 3, caractérisé en ce que le calcul (F17) de l'état de charge simulé (S) est réalisé à chaque intervalle de temps simulé ($\Delta$t) par soustraction à l'état de charge simulé précédent du rapport entre le produit du courant (i) simulé et de l'intervalle de temps ($\Delta$t) et d'un paramètre caractéristique de la batterie, représentatif de sa capacité (C).

5. Procédé selon la revendication 3, caractérisé en ce que la résistance interne (R) de la batterie est calculée (F13) pendant chaque intervalle de temps simulé, à partir d'un paramètre caractéristique de la batterie, représentatif de sa résistance interne (Ro) lorsqu'elle est complètement chargée, et de l'état de charge simulé (S) de la batterie.

6. Procédé selon la revendication 2, caractérisé en ce qu'il comporte le calcul (F6, F9) de l'état de charge réel (Sb) de la batterie, ledit état de charge réel étant utilisé comme état de charge simulé initial (S) lors de la simulation (F11) de la décharge de la batterie.

7. Procédé selon l'une quelconque des revendications 1 à 6, caractérisé en ce qu'il comporte la réactualisation des paramètres caractéristiques de la batterie, représentatifs de sa résistance interne (Ro) à l'état complètement chargé et de sa capacité (C), pour tenir compte du vieillissement de la batterie.

8. Procédé selon la revendication 7, caractérisé en ce que la réactualisation de la résistance interne (Ro) de la batterie à l'état complètement chargé comporte une augmentation progressive prédéterminée de ladite résistance interne (Ro).

9. Procédé selon l'une des revendications 7 et 8, caractérisé en ce que la réactualisation de la capacité (C) de la batterie comporte le calcul (F36) d'une nouvelle valeur de la capacité égale au rapport entre une valeur réactualisée de la résistance interne (Ro) de la batterie à l'état complètement chargé et un coefficient (k2) obtenu en faisant le produit des valeurs initiales de la capacité (C) et de la résistance interne à l'état complètement chargé (Ro).

10. Procédé selon l'une quelconque des revendications 1 à 9, caractérisé en ce qu'il comporte la détermination (F46) de la durée de vie (D) restante de la batterie à partir de la détermination de sa durée d'autonomie (T).

## Patentansprüche

1. Verfahren zur Bestimmung der Autonomiezeit (T) einer Batterie (2), das die Messung (F19, F4) der Spannung (Ub) an den Klemmen der Batterie sowie des Lade- und Entladestroms (Ib) der Batterie, die Berechnung (F6, F20) der Entladeleistung (Pb) der Batterie aus den gemessenen Spannungs- und Stromwerten und die Bestimmung der Autonomiezeit (T) der Batterie in Abhängigkeit von der Entladeleistung umfaßt, dadurch gekennzeichnet, daß die Bestimmung der Autonomiezeit (T) die iterative Simulation (F11) der Entladung der Batterie über aufeinanderfolgende simulierte Zeitintervalle ($\Delta$t) umfaßt, wobei die genannte Simulation in jedem simulierten Zeitintervall die Berechnung (F13, F14, F15, F17) einer simulierten Spannung (E) an den Klemmen der Batterie unter Berücksichtigung der Entladeleistung (Pb) und festgelegter spezifischer Kenngrößen ($R_o$, C, k) der Batterie, den Vergleich (F16) der simulierten Spannung (E) mit einer minimalen Entladespannung (Emin) der Batterie sowie die Addition (F17) der aufeinanderfolgenden simulierten Zeitintervalle umfaßt und die Autonomiezeit (T) der Batterie der Summe der Zeitintervalle entspricht, die sich ergibt, wenn die simulierte Spannung (E) die minimale Entladespannung (Emin) erreicht.

2. Verfahren nach Anspruch 1, dadurch gekennzeichnet, daß die Berechnung der simulierten Spannung (E) die Berechnung (F14) eines simulierten Entladestroms (i) sowie die Berechnung (F17) eines simulierten Ladezustands (S) der Batterie umfaßt.

3. Verfahren nach Anspruch 2, dadurch gekennzeichnet, daß die Berechnung (F14) des simulierten Entladestroms (i) nach der Gleichung

$$i = (E0 - \sqrt{E0^2 - 4RP}) / 2R$$

erfolgt, wobei E0 einer spezifischen Ersatzspannung der Batterie, R dem Innenwiderstand der Batterie und P der Entladeleistung der Batterie entsprechen.

4. Verfahren nach einem der Ansprüche 2 und 3, dadurch gekennzeichnet, daß die Berechnung (F17) des simulierten Ladezustands (S) in jedem simulierten Zeitintervall ($\Delta$t) durch Subtraktion des Verhältnisses zwischen dem Produkt aus dem simulierten Strom (i) und dem Zeitintervall ($\Delta$t) und einer, ihre Kapazität (C) abbildenden spezifischen Kenngröße der Batterie vom vorausgehenden simulierten Ladezustand erfolgt.

5. Verfahren nach Anspruch 3, dadurch gekennzeichnet, daß der Innenwiderstand (R) der Batterie in jedem simulierten Zeitintervall aus einer spezifischen Kenngröße der Batterie berechnet (F13) wird, die ihren Innenwiderstand ($R_0$) bei vollständiger Aufladung sowie den simulierten Ladezustand (S) der Batterie abbildet.

6. Verfahren nach Anspruch 2, dadurch gekennzeichnet, daß es die Berechnung (F6, F9) des tatsächlichen Ladezustands (Sb) der Batterie umfaßt, wobei der genannte tatsächliche Ladezustand bei der Simulation (F11) der Entladung der Batterie als simulierter Anfangsladezustand verwendet wird.

7. Verfahren nach irgendeinem der Ansprüche 1 bis 6, dadurch gekennzeichnet, daß es zur Berücksichtigung der Alterung der Batterie die Aktualisierung von spezifischen Kenngrößen der Batterie umfaßt, die ihren Innenwiderstand ($R_0$) im vollständig geladenen Zustand sowie ihre Kapazität (C) abbilden.

8. Verfahren nach Anspruch 7, dadurch gekennzeichnet, daß die Aktualisierung des Innenwiderstands ($R_0$) der Batterie im vollständig geladenen Zustand eine festgelegte kontinuierliche Erhöhung des genannten Innenwiderstands ($R_0$) umfaßt.

9. Verfahren nach einem der Ansprüche 7 und 8, dadurch gekennzeichnet, daß die Aktualisierung der Kapazität (C) der Batterie die Berechnung (F36) eines neuen Werts der Kapazität umfaßt, der dem Verhältnis zwischen einem aktualisierten Wert des Innenwiderstands ($R_0$) der Batterie im vollständig geladenen Zustand und einem Kennwert (k2) entspricht, welcher durch Bildung des Produkts aus den Anfangswerten der Kapazität (C) und des Innenwiderstands ($R_0$) im vollständig geladenen Zustand errechnet wird.

10. Verfahren nach irgendeinem der Ansprüche 1 bis 9, dadurch gekennzeichnet, daß es die Bestimmung (F46) der Restlebensdauer (D) der Batterie auf der Grundlage der Bestimmung ihrer Autonomiezeit (T) umfaßt.

**Claims**

1. A process for determining the backup time (T) of a battery (2), comprising measurement (F19, F4) of the voltage (Ub) at the battery terminals, and of the battery charge and discharge current (Ib), computation (F6, F20) of the discharge power (Pb) of the battery from the measured voltage and current values, and determination of the backup time (T) of the battery according to the discharge power, a process characterized in that determination of the backup time (T) comprises simulation (F11), in iterative manner, of discharge of the battery during successive simulated time intervals ($\Delta$t), said simulation comprising, for each simulated time interval, computation (F13, F14, F15, F17) of a simulated voltage (E) at the battery terminals taking into account the discharge power (Pb) and predetermined parameters (Ro, C, k) characteristic of the battery, comparison (F16) of the simulated voltage (E) to a minimum discharge voltage (Emin) of the battery, and summing (F17) of the successive simulated time intervals, the battery backup time (T) being equal to the sum of the time intervals obtained when the simulated voltage (E) reaches the minimum discharge voltage (Emin).

2. The process according to claim 1, characterized in that computation of the simulated voltage (E) comprises computation (F14) of a simulated discharge current (i) and computation (F17) of a simulated state of charge (S) of the battery.

3. The process according to claim 2, characterized in that computation (F14) of the simulated discharge current (i) is performed according to the equation

$$i = (Eo - \sqrt{Eo^2 - 4RP}) / 2R,$$

in which Eo is an equivalent voltage characteristic of the battery, R the internal resistance of the battery and P the discharge power of the battery.

4. The process according to one of the claims 2 and 3, characterized in that computation (F17) of the simulated state of charge (S) is performed at each simulated time interval ($\Delta$t) by subtracting from the previous simulated state of charge the ratio between the product of the simulated current (i) and of the time interval ($\Delta$t) and a parameter characteristic of the battery representative of its capacity (C).

5. The process according to claim 3, characterized in that the internal resistance (R) of the battery is computed (F13) during each simulated time interval from a parameter characteristic of the battery representative of its internal resistance (Ro) when it is fully charged, and the simulated state of charge (S) of the battery.

6. The process according to claim 2, characterized in that it comprises computation (F6, F9) of the actual state of charge (Sb) of the battery, said actual state of charge being used as the initial simulated state of charge (S) when simulation (F11) of discharge of the battery is performed.

7. The process according to any one of the claims 1 to 6, characterized in that it comprises re-updating of the parameters characteristic of the battery representative of its internal resistance (Ro) in the fully charged state and of its capacity (C), to take account of ageing of the battery.

8. The process according to claim 7, characterized in that re-updating of the internal resistance (Ro) of the battery in the fully charged state comprises a preset progressive increase of said internal resistance (Ro).

9. The process according to one of the claims 7 and 8, characterized in that re-updating of the battery capacity (C) comprises computing (F36) of a new value of the capacity equal to the ratio between a re-updated value of the internal resistance (Ro) of the battery in the fully charged state and a coefficient (k2) obtained by making the product of the initial values of the capacity (C) and of the internal resistance in the fully charged state (Ro).

10. The process according to one of the claims 1 to 9, characterized in that it comprises determination (F46) of the remaining lifetime (D) of the battery from determination of its backup time (T).

Charge

Affichage

μP

RAM

Ib

Ub

Fig. 1

R    i →

E₀

E

Fig . 2

De  F1

P = 0            F  47

Sb = 1
A = 0            F  48

vers F4

Fig . 7

F1 — Batterie chargée ?

N → F2 — Affichage : charger la batterie

O

F3 — Initialisation

F4 — Mesure Ib

F5 — Décharge ?

N → F7 — Charge ?

O → F9 — Calcul de Sb

F6 — Calcul de P et Sb

O

N → F8 — P = Pth

F10 — S = Sb

F11 — Calcul de T

F46 — Calcul de D

F12 — Affichage de T

Fig. 3

De   F10

$$R = R_o/S^k$$  F 13

$$i = \frac{E_o - \sqrt{E_o^2 - 4RP}}{2R}$$  F 14

$$E = E_o - R\,i$$  F 15

$E \leqslant E\,min\,?$  F 16

O

N

$$S = S - i\,\Delta t/C$$
$$T = T + \Delta t$$  F17

vers F12

Fig. 4

De F5

F 18
$$T1 = 0$$

F 19
Mesure Ub

F 20
$$Pb = Ub \cdot Ib$$

F 21
$$Sb = Sb - \frac{Ib \, \triangle T1}{C}$$

F 22
$$P = Pb \, ?$$  → O

N

F 24
$$P = Pb$$

F 25
$$T = 0$$

F 23
$$T = T - \triangle T1$$

vers F 10

vers F 12

Fig . 5

De F7

F 26

$$Sb = Sb + \frac{Ib \triangle T1}{aC}$$

F 27

$$T1 = T1 + \triangle T1$$

F 28

Sb = 1 ?

0

N

F 29

T1 = 12 h ?

0

N

F 30

Sb = 1

F 46

A = 0

F 31

Calcul de R₀

vers F4

Fig. 6

De F30

F32

Mesure Ub

F33

$$Rob = \frac{Eo-Ub}{Ib}$$

F34

Rob > k1Ro ?    N

O

F35

Ro = Rob

F36

$$C = \frac{k2}{Ro}$$

vers F4

Fig . 8

De F19

*F37*

Ub=Emin ? — N

O

*F39*
$$R = \frac{Eo - Ub}{Ib}$$

*F38*
$$A = A + Ib\Delta T1$$

*F40*
$$S^k = \frac{Ro}{R}$$

*F41*
Calcul de S

*F42*
$$A = A + Ib\,\triangle T1$$

*F43*
$$C = \frac{A}{1-S}$$

*F44*

Cb < k3C ? — N

O

*F45*
$$C = Cb$$

vers F20

Fig.9

17

Fig.10